# EUROPÄISCHE PATENTSCHRIFT

(11) **EP 2 190 270 B1**
(45) Veröffentlichungstag und Bekanntmachung des Hinweises auf die Patenterteilung: **15.02.2012**
(21) Anmeldenummer: 09174434.2
(22) Anmeldetag: 29.10.2009
(51) Int. Cl.: H05K 1/00

(54) **Schaltungsplatte und Verfahren zur Herstellung einer Schaltungsplatte**
Circuit board and method for its manufacture
Plaque de commutation et procédé de fabrication d'une plaque de commutation

(30) Priorität: 21.11.2008 DE 102008058490; 20.11.2008 US 116450 P
(43) Veröffentlichungstag der Anmeldung: 26.05.2010
(73) Patentinhaber: Continental Automotive GmbH, 30165 Hannover (DE)
(72) Erfinder: Motsch, Hans-Werner, 85049 Ingolstadt (DE); Schels, Florian, 92358 Seubersdorf (DE); Smirra, Karl, 83512 Wasserburg (DE)

(56) Entgegenhaltungen:
- DE-A1- 2 724 399
- DE-A1- 2 834 525

## Beschreibung

Die Erfindung betrifft eine Schaltungsplatte und ein Verfahren zur Herstellung einer Schaltungsplatte.

Schaltungsplatten, die auch üblicherweise als gedruckte Schaltungen oder Printplatten bezeichnet werden, bilden eine Struktur, mittels der elektrische Signale und/oder Strom von einem Punkt zu einem anderen Punkt über eine gewünschte Distanz übertragen werden können. Eine Schaltungsplatte kann auch die darauf montierten Komponenten mechanisch lagern. Schaltungsplatten besitzen typischerweise ein elektrisch isolierendes Substrat und eine Vielzahl von elektrisch leitenden Bahnen oder Leitungen, die auf dem elektrisch isolierenden Substrat in einem gewünschten Muster angeordnet sind, um die gewünschte Verdrahtungsanordnung zu bilden.

Das Material des Substrates kann so ausgewählt werden, dass eine starre Schaltungsplatte vorgesehen wird. Beispielweise kann eine faserverstärkte Epoxidharzplatte oder eine Keramikplatte als Substrat Verwendung finden. Für einige Anwendungsfälle ist jedoch eine kompliziertere dreidimensionale Verdrahtungsstruktur erforderlich.

Eine dreidimensionale Verdrahtungsstruktur kann mit Hilfe eines flexiblen Band- oder Foliensubstrates, wie beispielsweise einer Polyimidfolie, vorgesehen werden, das gebogen und/oder gefaltet werden kann, um eine flexible Schaltungsplatte auszubilden, die sich in drei Dimensionen erstreckt. Eine Anordnung, die zwei miteinander verriegelte flexible Schaltungsplatten für eine Flüssigkristallanzeige bildet, ist aus der US 7,212,413 bekannt.

Obwohl flexible Schaltungsplatten den Vorteil besitzen, dass sie eine anpassungsfähige dreidimensionale Verdrahtungsstruktur bilden, sind flexible Schaltungsplatten gegenwärtig typischerweise teurer als starre Schaltungsplatten. Es ist generell wünschenswert, die Kosten von Komponenten zu reduzieren, um in der Lage zu sein, die Kosten der erzeugten Produkte zu verringern oder den Gewinn zu erhöhen.

Es ist ein Ziel der vorliegenden Erfindung, eine Verdrahtungsstruktur mit geringen Kosten zu schaffen, die für eine Verwendung in einem großen Bereich von Anwendungsfällen geeignet ist.

Dieses Ziel wird mit dem Gegenstand der unabhängigen Patentansprüche erreicht. Weitere vorteilhafte Ausführungsformen sind Gegenstand der abhängigen Ansprüche.

Die Erfindung sieht eine starre Schaltungsplatte vor, die mindestens ein integrales Glied besitzt, das so ausgebildet ist, dass es eine vorgegebene Bewegung an einem freien Ende des Gliedes in mindestens zwei zueinander senkrechten Ebenen durchführen kann. Das Glied erstreckt sich in mindestens einer Schleife, wobei es sich bei der Schleife um eine generell U-förmige Schleife mit einer offenen Seite und einer geschlossenen Seite handelt. Die offene Seite ist in der Ebene des Gliedes und das geschlossene Ende außerhalb der Ebene des Gliedes angeordnet, und die Schleife ist aus der Ebene des Gliedes herausgebogen.

Der hier verwendete Begriff "starr" soll eine flexible Schaltungsplatte auf Folien- oder Bandbasis, beispielsweise auf Basis eines Polyimidbandes, ausschließen. Der hier verwendete Begriff "integral" soll verdeutlichen, dass das Glied und der andere sich anschließende Abschnitt der starren Schaltungsplatte einstückig ausgebildet sind. Der verwendete Begriff "Glied" soll einen vorstehenden Bereich bezeichnen, der generell länglich ausgebildet ist.

Es wird eine starre Schaltungsplatte vorgesehen, die aus Materialien hergestellt werden kann, welche mit geringeren Rohmaterialkosten verbunden sind, wobei die Schaltungsplatte gleichzeitig mindestens einen Bereich, insbesondere das freie Ende des integralen Gliedes, aufweist, der beweglich ist. Diese Bewegung kann dazu benutzt werden, um eine starre Schaltungsplatte mit räumlicher Toleranzkompensation vorzusehen, die durch das freie Ende des Gliedes erreicht wird.

Beispielsweise kann die vorgegebene Bewegung kleine Änderungen in der Position einer Komponente, die auf der Schaltungsplatte montiert oder an diese angeschlossen werden soll, kompensieren. Diese Bewegung kann ferner vorgegeben sein, um eine räumliche Toleranz des freien Endes des Gliedes vorzusehen, wenn dieses freie Ende des Gliedes an einen zweiten Anschluss angepasst oder in einen Schlitz oder ein Durchgangsloch eingepasst werden soll.

Steuersysteme für mechatronische Anwendungsfälle finden oft in aggressiven Umgebungen Verwendung, wie beispielsweise in einem Motor oder im heißen Öl des Getriebes. Die elektronischen Komponenten sind in einem abgedichteten Modul untergebracht, der einen Anschluss durch das Gehäuse des Moduls aufweist, damit die darin befindlichen Komponenten an weitere Komponenten außerhalb des Gehäuses angeschlossen werden können. Das bewegliche freie Ende des Gliedes kann für eine Dimensionstoleranz sorgen, um Variationen in der Herstelltoleranz des Gehäuses und/oder der starren Schaltungsplatte zu kompensieren, so dass das freie Ende des Gliedes in zuverlässiger Weise in den Anschluss im Gehäuse eingepasst werden kann.

Das Glied ist so geformt, dass es eine Bewegung in mindestens zwei zueinander senkrechten Richtungen eines Bereiches des Gliedes durchführen kann, der in Bezug auf den geformten Bereich des Gliedes peripher ist. Insbesondere ist die Länge des Gliedes so ausgebildet, dass dieses eine Bewegung am freien Ende des Gliedes in mindestens zwei zueinander senkrechten Richtungen durchführen kann.

Bei einer Ausführungsform umfasst das freie Ende des Gliedes mindestens einen Kontaktbereich. Dieser Kontaktbereich kann irgendeine wünschenswerte Form besitzen, beispielsweise als Kontaktpad oder Kontaktstift oder als Kontaktfassung ausgebildet sein.

Der Kontaktbereich kann am am stärksten bewegbaren Abschnitt des Gliedes angeordnet sein, d. h. am freien Ende, um für eine zuverlässige elektrische Verbindung mit der starren Schaltungsplatte zu sorgen.

Bei einer weiteren Ausführungsform ist das Glied so geformt, dass es eine vorgegebene Bewegung in drei zueinander senkrechten Ebenen durchführen kann. Das Glied kann auch so geformt sein, dass es für eine dreidimensionale Elastizität des freien Endes des Gliedes sorgt. Diese dreidimensionale Elastizität kann dazu dienen, einen guten elektrischen Kontakt zwischen einem Kontaktbereich am freien Ende und einer weiteren Komponente herzustellen, indem die elektrische Verbindung mit mindestens einem gewissen Federungsvermögen versehen wird.

Das Glied kann auf eine Vielzahl von Weisen geformt sein, um für eine vorgesehene Bewegung am freien Ende des Gliedes zu sorgen. Beispielsweise kann die Länge des Gliedes eine Falte, eine Kinke und/oder einen verengten Abschnitt aufweisen.

Das Glied erstreckt sich in mindestens einer Schleife, wobei diese Schleife so geformt ist, dass sie für eine vorgegebene Bewegung am freien Ende des Gliedes sorgt. Das Glied ist daher nicht geradlinig ausgebildet, sondern besitzt eine mäandrierende Form.

Bei der Schleife handelt es sich um eine generell U-förmige Schleife mit einer offenen Seite und einer geschlossenen Seite, wobei die offene Seite in der Ebene der starren Schaltungsplatte und das geschlossene Ende außerhalb der Ebene der Schaltungsplatte angeordnet sind.

Eine derartige Form kann einfach hergestellt werden, indem die gewünschte Form der starren Schaltungsplatte ausgestanzt und dann die starre Schaltungsplatte im Bereich des geschlossenen Endes der Schleife gebogen wird. Eine starre Schaltungsplatte kann gebogen werden, indem sie um eine Formungseinheit gebogen wird. Während die starre Schaltungsplatte gebogen wird, kann auch Wärme aufgebracht werden.

Die Schleife kann so gebogen werden, dass sie einen Krümmungsradius zwischen 5 mm und 30 mm besitzt. Der minimale Krümmungsradius, der möglich ist, ohne die Platte zu zerbrechen, kann von der Sprödigkeit der Materialien der starren Schaltungsplatte sowie von der Dicke der starren Schaltungsplatte abhängen. Der Krümmungsradius kann auch so ausgewählt sein, dass er für die gewünschte vorgegebene Bewegung sorgt.

Die starre Schaltungsplatte der vorliegenden Anmeldung kann unter Verwendung einer herkömmlichen starren Schaltungsplatte geformt werden und kann ein elektrisch isolierendes Substrat umfassen, das einen oder mehrere der nachfolgenden Materialien aufweist: FR-2 (Phenolharzbaumwollpapier), FR-3 (Baumwollpapier und Epoxidharz), FR-4 (Glasgewebe und Epoxidharz), FR-5 (Glasgewebe und Epoxidharz), FR-6 (Matte-Glas und Polyester), G-10 (Glasgewebe und Epoxidharz), CEM-1 (Baumwollpapier und Epoxidharz), CEM-2 (Baumwollpapier und Epoxidharz), CEM-3 (Glasgewebe und Epoxidharz), CEM-4 (Glasgewebe und Epoxidharz), CEM-5 (Glasgewebe und Polyester).

Die starre Schaltungsplatte kann einseitig ausgebildet sein und elektrisch leitende Bahnen aufweisen, die auf einer einzigen Seite eines elektrisch isolierenden starren Substrates angeordnet sind. Die starre Schaltungsplatte kann jedoch auch zweiseitig ausgebildet sein, wobei sich Bahnen auf beiden gegenüberliegenden Hauptflächen befinden, und kann des Weiteren elektrisch leitende Wege besitzen, um die Bahnen auf den zwei gegenüberliegenden Hauptflächen miteinander zu verbinden. Die starre Schaltungsplatte kann auch als Mehrschichtschaltungsplatte ausgebildet sein.

Die Anmeldung sieht ferner ein mechatronisches Steuersystem vor, das eine starre Schaltungsplatte gemäß einer der vorstehend beschriebenen Ausführungsformen aufweist. Bei einer Ausführungsform handelt es sich bei dem mechatronischen Steuersystem um einen Steuermodul für ein automatisches Getriebe.

Bei einer weiteren Ausführungsform umfasst die starre Schaltungsplatte eine Vielzahl von gebogenen Abschnitten, wobei elektronische Komponenten des mechatronischen Steuersystems auf den gebogenen Abschnitten angeordnet sind und/oder elektrisch hiermit verbunden sind. Die gebogenen Abschnitte können in einer vorgegebenen Weise bewegbar sein oder auch nicht. Die gebogenen Abschnitte können dazu dienen, um eine starre Schaltungsplatte mit einer dreidimensionalen Kontur zu schaffen. Eine dreidimensionale Kontur ermöglicht eine Anpassung der Form der starren Schaltungsplatte an die Position der mechanischen Komponenten.

Die Anmeldung sieht ferner ein Verfahren zum Vorsehen einer räumlichen Toleranzkompensation in einer starren Schaltungsplatte vor. Eine starre Schaltungsplatte wird zur Verfügung gestellt, die mindestens ein integrales Glied besitzt. Das Glied ist so geformt, dass es für eine vorgegebene Bewegung eines freien Endes des Gliedes in mindestens zwei zueinander senkrechten Ebenen sorgt. Die starre Vorläuferschaltungsplatte wird gestanzt, um ein Glied mit einer Schleife vorzusehen, die sich in der Ebene des Gliedes erstreckt. Die Schleife wird in einer Richtung aus der Ebene des Gliedes heraus gebogen.

Die starre Schaltungsplatte kann einfach hergestellt werden, so dass eine starre Schaltungsplatte vorgesehen werden kann, die mindestens einen beweglichen Abschnitt besitzt, der für eine räumliche Toleranz sorgt.

Bei einer ersten Ausführungsform ist eine starre Vorläuferschaltungsplatte so geformt, dass das freie Ende des Gliedes den mindestens einen Kontaktbereich umfasst. Die starre Vorläuferschaltungsplatte kann so vorgesehen sein, dass sie einen generell quadratischen oder rechteckigen Umriss besitzt, der die gewünschte Verdrahtungsstruktur in der Form von elektrisch leitenden Bahnen und Kontaktbereichen aufweist. Eine Platte mit einem quadratischen oder rechteckigen Umriss ist einfacher und lässt sich billiger in großen Mengen herstellen.

Diese starre Vorläuferschaltungsplatte kann dann so geformt werden, dass sie mindestens ein integrales Glied aufweist, und kann so geformt werden, dass mindestens ein Kontaktbereich an einem Ende des Gliedes vorgesehen ist.

Die starre Vorläuferschaltungsplatte wird durch Stanzen geformt, um ein Glied vorzusehen und um ein Glied mit einer Schleife, die sich in der Ebene des Gliedes erstreckt, auszubilden.

Nachdem die starre Schaltungsplatte mit dem mindestens einen integralen Glied aus der starren Vorläuferschaltungsplatte gestanzt worden ist, wird die Schleife in einer Richtung aus der Ebene des Gliedes herausgebogen. Mindestens ein Abschnitt der Schleife erstreckt sich daher in Richtung aus der Ebene des Gliedes heraus, um für eine Bewegung am freien Ende des Gliedes in mindestens zwei zueinander senkrechten Richtungen zu sorgen.

Bei einer weiteren Ausführungsform ist die Schleife in einer Richtung aus der Ebene des Gliedes heraus auf permanente Weise gebogen, d. h. nach Druckabbau wird die Position des Gliedes außerhalb der Ebene zum größten Teil aufrechterhalten.

In Verbindung mit den beigefügten Zeichnungen werden nunmehr Ausführungsformen der Erfindung beschrieben. Es zeigen:
- Figur 1: eine perspektivische Ansicht einer starren Schal- tungsplatte gemäß einer Ausführungsform,
- Figur 2: eine vergrößerte Ansicht des Bereiches A in Figur 1,
- Figur 3: eine vergrößerte Ansicht des Bereiches B in Figur 1 und
- Figur 4: eine schematische Teilschnittansicht einer starren Schaltungsplatte.

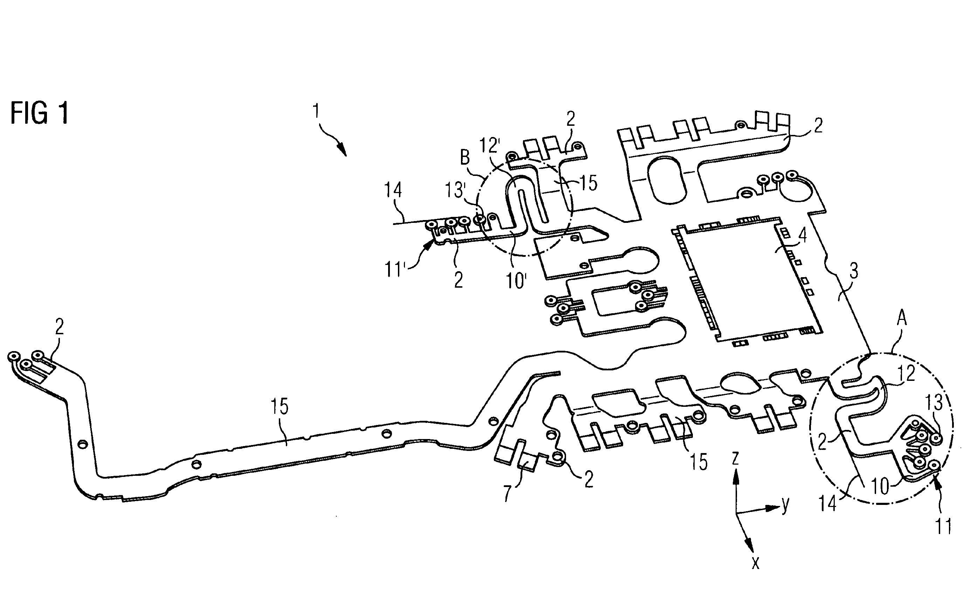

Figur 1 zeigt eine perspektivische Ansicht einer starren Schaltungsplatte 1 gemäß einer ersten Ausführungsform.

Die starre Schaltungsplatte 1 ist so geformt, dass sie eine Vielzahl von integralen Gliedern 2 aufweist, die sich von einem zentralen Bereich 3 aus erstrecken, der ein generell rechteckiges Durchgangsloch 4 zur Aufnahme eines nicht dargestellten elektronischen Moduls besitzt, welcher eine Vielzahl von elektronischen Komponenten aufweist.

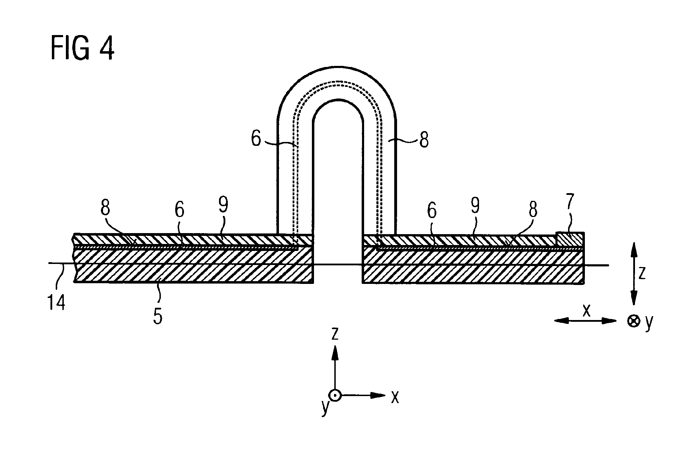

Die Struktur der starren Schaltungsplatte ist in der Teilschnittansicht der Figur 4 gezeigt. Die starre Schaltungsplatte 1 umfasst ein dielektrisches Substrat 5 und eine Vielzahl von elektrisch leitenden Kupferbahnen 6 und Kontaktbereichen 7, die auf der Oberseite 8 des dielektrischen Substrates 6 angeordnet sind. Die Kupferbahnen sind mit einer weiteren Isolationsschicht 9 bedeckt, die die Kontaktbereiche 7 freilässt. Bei weiteren nichtdargestellten Ausführungsformen hat die starre Schaltungsplatte 1 eine doppelseitige Struktur oder eine Mehrschichtstruktur.

Die starre Schaltungsplatte 1 umfasst zwei integrale Glieder 10, 10', die so geformt sind, dass sie für eine vorgegebene Bewegung an einem freien Ende 11, 11' des Gliedes 10, 10' in mindestens zwei zueinander senkrechten Ebenen sorgen.

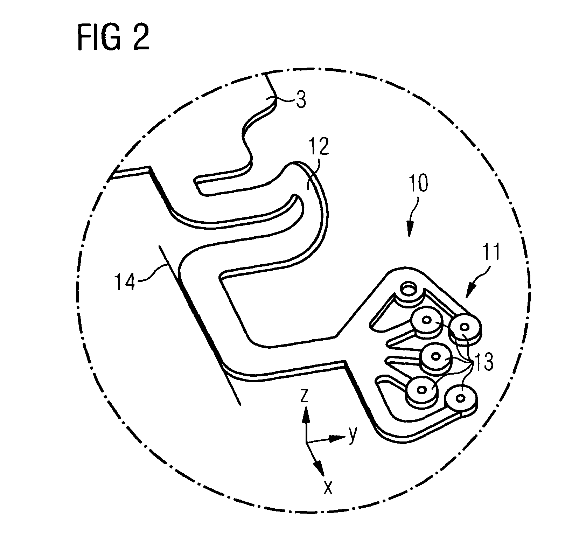

Das erste Glied 10 mit einem freien Ende, das in mindestens zwei zueinander senkrechten Ebenen bewegbar ist, ist in Figur 1 mit dem Bezugszeichen A versehen und in Figur 2 in einer vergrößerten Ansicht dargestellt.

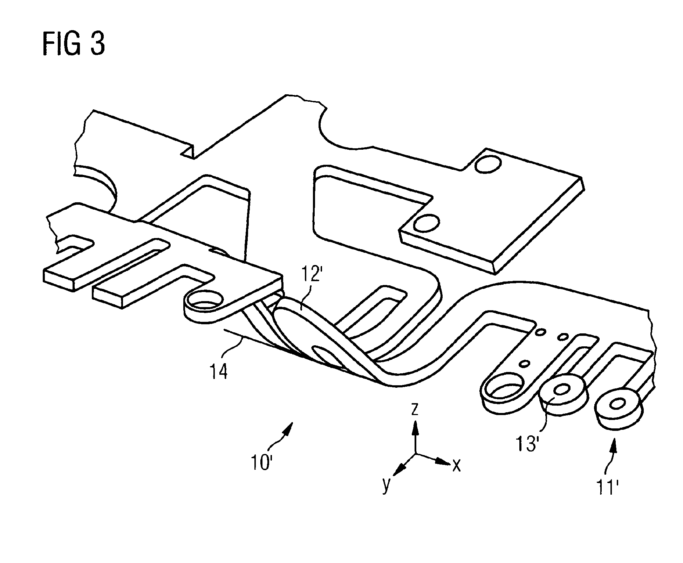

Das zweite integrale Glied 10', das so geformt ist, dass es das freie Ende 11' mit einer vorgegebenen Bewegung in mindestens zwei zueinander senkrechten Ebenen versieht, ist mit dem Bezugszeichen B versehen und in Figur 3 in einer vergrößerten Ansicht dargestellt.

Ein erstes integrales Glied 10, das so geformt ist, dass es eine vorgegebene Bewegung in drei zueinander senkrechten Ebenen vorsieht, ist in Figur 2 gezeigt. Das Glied 10 ist so geformt, dass es sich mäanderförmig erstreckt, und besitzt eine generell U-förmige Schleife 12. Die Seiten des U's erstrecken sich generell senkrecht zu den benachbarten Bereichen des Gliedes 10. Die offene Seite der U-förmigen Schleife 12 ist in der Ebene 14 des Gliedes 10 angeordnet, und das geschlossene Ende der U-förmigen Schleife 12 ist nach oben aus der Ebene 14 des Gliedes 10 herausgebogen. Das gebogene Glied 10 mit seiner Schleife 12 ermöglicht eine Bewegung des freien Endes 11 des Gliedes 10 in x-Richtung, y-Richtung und z-Richtung, wie in Figur 2 angedeutet.

Bei dieser Ausführungsform ist das freie Ende 11 des Gliedes 10 in fünf Finger unterteilt, die jeweils in einem kreisförmigen Kontaktbereich enden. Die kreisförmigen Kontaktbereiche 13 sind am Ende des freien Endes 11 des Gliedes 10 angeordnet und in drei zueinander senkrechten Ebenen bewegbar, so dass eine räumliche Toleranzkompensation vorgesehen wird.

Ein Glied 2, das sich generell in einer Richtung erstreckt, beispielsweise ein geradliniges rechteckförmiges Glied, kann in einer einzigen Ebene senkrecht zur Oberseite des Gliedes, d. h. in Figur 1 in z-Richtung, bewegbar sein. Durch Anordnung einer Schleife 12, die sich in der Ebene des Gliedes 10 erstreckt, kann sich das freie Ende 11 des Gliedes 10 nunmehr nicht nur in z-Richtung, sondern auch in x-Richtung bewegen, indem die Breite der U-förmigen Schliefe 12 geöffnet und geschlossen wird, um Unterschiede im Abstand des freien Endes 11 des Gliedes 10 vom Hauptteil 3 der starren Schaltungsplatte 1 zu kompensieren.

Durch das Biegen des geschlossenen Endes der U-förmigen Schleife 12 aus der Ebene 14 des Gliedes 10 heraus kann sich das freie Ende 11 des Gliedes 10 auch in y-Richtung bewegen und ist daher in drei zueinander senkrechten Ebenen bewegbar.

Figur 3 ist eine vergrößerte Ansicht des Bereiches B der Figur 1. Gezeigt ist ein zweites Glied 10', das so geformt ist, dass es eine Bewegung am freien Ende 11' des Gliedes 10' in drei zueinander senkrechten Richtungen ermöglicht. Wie bei dem ersten Glied 10 besitzt auch das zweite Glied 10' eine Schleife 12' in seiner Länge und eine Vielzahl von Kontaktbereichen 13', die an seinem freien Ende 11' angeordnet sind. Das Glied 10' erstreckt sich generell in x-Richtung. Die Schleife 12' erstreckt sich in y-Richtung und ist nach oben aus der Ebene 14 des Gliedes 10' in z-Richtung herausgebogen.

Für eine vereinfachte Darstellung sind die Bewegungsrichtungen in Verbindung mit der Teilschnittansicht eines Gliedes in Figur 4 dargestellt. Das Glied erstreckt sich generell in der x-y-Ebene und besitzt eine Schleife, die sich generell in y-Richtung erstreckt und in z-Richtung aus der x-y-Ebene 14 nach oben herausgebogen ist.

Die starre Schaltungsplatte 1 kann hergestellt werden, indem die gewünschte Außenkontur einschließlich der integralen Glieder 2, 10, 10' und Schleifen 12, 12' aus einer rechteckigen oder quadratischen starren Schaltungsplatte herausgestanzt wird. Ein Glied 10 mit der Schleife 12 kann dann weiter bearbeitet werden, um das geschlossene Ende der Schleife 12 aus der Ebene 14 des Gliedes 10 herauszubiegen und damit eine Bewegung am freien Ende 11 des Gliedes 10 in drei zueinander senkrechten Richtungen zu ermöglichen. In der Ansicht der Figur 4 kann das geschlossene Ende der Schleife in Bezug auf die Ebene 14 des Gliedes 10 auch abwärts gebogen sein sowie aufwärts wie in Figur 4 gezeigt.

Die starre Schaltungsplatte 1 umfasst ferner eine Vielzahl von gebogenen oder verformten Abschnitten 15, die die Herstellung von Anschlüssen an weitere Komponenten ermöglichen, deren Position durch den jeweiligen Anwendungsfall vorgegeben ist. Diese gebogenen Abschnitte 15 können eine Bewegung in einer einzigen Richtung ermöglichen, d. h. in z-Richtung senkrecht zur Oberseite der Schaltungsplatte für die sich in einem Glied 2 erstreckenden gebogenen Abschnitte 15.

Es wird daher eine starre Schaltungsplatte 1 vorgesehen, die stabile, im Wesentlichen unbewegliche Bereiche 15 sowie mindestens ein Glied 10, 10' aufweist, das so geformt ist, dass es eine Bewegung im freien Ende 11, 11' des Gliedes 10, 10' ermöglicht. Eine starre Schaltungsplatte 1 mit räumlicher Toleranz kann vorgesehen werden, ohne dabei ein teureres flexibles Schaltungsplattenmaterial zu benötigen. Ferner werden zusätzliche Anschlüsse zwischen einer flexiblen Schaltungsplatte und einer starren Schaltungsplatte vermieden, so dass die Montagekosten verringert werden.

## Patentansprüche

1. Starre Schaltungsplatte (1) mit mindestens einem integralen Glied (10; 10'), das so geformt ist, dass es eine vorgegebene Bewegung an einem freien Ende (11; 11') des Gliedes (10; 10') in mindestens zwei zueinander senkrechten Ebenen durchführen kann,
**dadurch gekennzeichnet, dass**
sich das Glied (10; 10') in mindestens einer Schleife (12; 12') erstreckt, wobei es sich bei der Schleife (12; 12') um eine generell U-förmige Schleife mit einer offenen Seite und einer geschlossenen Seite handelt, wobei die offene Seite in der Ebene (14) des Gliedes (10; 10') und das geschlossene Ende außerhalb der Ebene (14) des Gliedes (10; 10') angeordnet sind und die Schleife (12; 12') aus der Ebene (14) des Gliedes (10; 10') herausgebogen ist.

2. Starre Schaltungsplatte (1) nach Anspruch 1, **dadurch gekennzeichnet, dass** das freie Ende (11; 11') des Gliedes (10; 10') mindestens einen Kontaktbereich (13) umfasst.

3. Starre Schaltungsplatte (1) nach Anspruch 1 oder 2, **dadurch gekennzeichnet, dass** das Glied (10; 10') so geformt ist, dass es eine vorgegebene Bewegung am freien Ende des Gliedes (10; 10') in drei zueinander senkrechten Ebenen durchführen kann.

4. Starre Schaltungsplatte (1) nach einem der Ansprüche 1-3, **dadurch gekennzeichnet, dass** das Glied (10; 10') so geformt ist, dass es für eine dreidimensionale Elastizität des freien Endes (11; 11') des Gliedes (10; 10') sorgt.

5. Starre Schaltungsplatte (1) nach einem der Ansprüche 1-4, **dadurch gekennzeichnet, dass** die starre Schaltungsplatte (1) ein elektrisch isolierendes Substrat (5) aufweist, das eines der folgenden Materialien umfasst: FR-2 (Phenolharzbaumwollpapier), FR-3 (Baumwollpapier und Epoxidharz), FR-4 (Glasgewebe und Epoxidharz), FR-5 (Glasgewebe und Epoxidharz), FR-6 (Matte-Glas und Polyester), G-10 (Glasgewebe und Epoxidharz), CEM-1 (Baumwollpapier und Epoxidharz), CEM-2 (Baumwollpapier und Epoxidharz), CEM-3 (Glasgewebe und Epoxidharz), CEM-4 (Glasgewebe und Epoxidharz), CEM-5 (Glasgewebe und Polyester).

6. Mechatronisches Steuersystem mit einer starren Schaltungsplatte (1) nach einem der Ansprüche 1-5.

7. Mechatronisches Steuersystem nach Anspruch 6, **dadurch gekennzeichnet, dass** die starre Schaltungsplatte (1) eine Vielzahl von gebogenen Abschnitten (15) aufweist, wobei elektronische Komponenten des mechatronischen Steuersystems auf den gebogenen Abschnitten angeordnet und/oder hiermit elektrisch verbunden sind.

8. Mechatronisches Steuersystem nach Anspruch 5 oder 6, **dadurch gekennzeichnet, dass** es ein Steuermodul eines automatischen Getriebes ist.

9. Verfahren zur Herstellung einer Schaltungsplatte (1) mit den folgenden Schritten:
- Vorsehen einer starren Schaltungsplatte (1), die mindestens ein integrales Glied (10; 10') aufweist, und
- Formen des Gliedes (10; 10') derart, dass ein freies Ende (11; 11') des Gliedes (10; 10') eine vorgegebene Bewegung in mindestens zwei zueinander senkrechten Ebenen durchführen kann,
**dadurch gekennzeichnet, dass**
die starre Vorläuferschaltungsplatte (1) gestanzt wird, um ein Glied (10; 10') mit einer Schleife (12; 12') vorzusehen, die sich in der Ebene (14) des Gliedes (10; 10') erstreckt, und die Schleife (12; 12') in einer Richtung aus der Ebene (14) des Gliedes (10; 10') heraus gebogen wird.

10. Verfahren nach Anspruch 9, **dadurch gekennzeichnet, dass** eine starre Vorläuferschaltungsplatte so geformt wird, dass das freie Ende (11; 11') des Gliedes (10; 10') mindestens einen Kontaktbereich (13; 13') aufweist.

## Claims

1. Rigid circuit board (1) with at least one integral element (10; 10'), which is formed such that it can perform a predetermined movement at a free end (11; 11') of the element (10; 10') in at least two planes that are perpendicular to one another, **characterized in that** the element (10; 10') extends in at least one loop (12; 12'), the loop (12; 12') being a generally U-shaped loop with an open side and a closed side, the open side being arranged in the plane (14) of the element (10; 10') and the closed end being arranged outside the plane (14) of the element (10; 10') and the loop (12; 12') being bent out from the plane (14) of the element (10; 10').

2. Rigid circuit board (1) according to Claim 1, **characterized in that** the free end (11; 11') of the element (10; 10') comprises at least one contact region (13).

3. Rigid circuit board (1) according to Claim 1 or 2, **characterized in that** the element (10; 10') is formed such that it can perform a predetermined movement at the free end of the element (10; 10') in three planes that are perpendicular to one another.

4. Rigid circuit board (1) according to one of Claims 1-3, **characterized in that** the element (10; 10') is formed such that it provides a three-dimensional elasticity of the free end (11; 11') of the element (10; 10').

5. Rigid circuit board (1) according to one of Claims 1-4, **characterized in that** the rigid circuit board (1) has an electrically insulating substrate (5), which comprises one of the following materials: FR-2 (phenolic resin cotton paper), FR-3 (cotton paper and epoxy resin), FR-4 (glass fabric and epoxy resin), FR-5 (glass fabric and epoxy resin), FR-6 (matte glass and polyester), G-10 (glass fabric and epoxy resin), CEM-1 (cotton paper and epoxy resin) CEM-2 (cotton paper and epoxy resin), CEM-3 (glass fabric and epoxy resin), CEM-4 (glass fabric and epoxy resin), CEM-5 (glass fabric and polyester).

6. Mechatronic control system with a rigid circuit board (1) according to one of Claims 1-5.

7. Mechatronic control system according to Claim 6, **characterized in that** the rigid circuit board (1) has a multiplicity of bent portions (15), electronic components of the mechatronic control system being arranged on the bent portions and/or electrically connected thereto.

8. Mechatronic control system according to Claim 5 or 6, **characterized in that** it is a control module of an automatic transmission.

9. Method for manufacturing a circuit board (1) with the following steps:
- providing a rigid circuit board (1), which has at least one integral element (10; 10'), and
- forming the element (10; 10') in such a way that a free end (11; 11') of the element (10; 10') can perform a predetermined movement in at least two planes that are perpendicular to one another,
**characterized in that**
the rigid circuit board preform (1) is stamped in order to provide an element (10; 10') having a loop (12; 12') which extends in the plane (14) of the element (10; 10'), and the loop (12; 12') is bent in a direction out of the plane (14) of the element (10; 10').

10. Method according to Claim 9, **characterized in that** a rigid circuit board preform is formed such that the free end (11; 11') of the element (10; 10') has at least one contact region (13; 13').

## Revendications

1. Carte rigide de circuit imprimé (1) avec au moins un élément intégral (10 ; 10') qui est formé de sorte qu'il puisse réaliser un mouvement prédéfini à une extrémité libre (11 ; 11') de l'élément (10 ; 10') dans au moins deux plans perpendiculaires l'un à l'autre,
**caractérisée en ce que**
l'élément (10 ; 10') s'étend dans au moins une boucle (12 ; 12'), où la boucle (12 ; 12') est globalement une boucle en forme de U avec un côté ouvert et un côté fermé, le côté ouvert étant agencé dans le plan (14) de l'élément (10 ; 10') et l'extrémité fermée étant agencée à l'extérieur du plan (14) de l'élément (10 ; 10') et la boucle (12 ; 12') étant repliée hors du plan (14) de l'élément (10 ; 10').

2. Carte rigide de circuit imprimé (1) selon la revendication 1, **caractérisée en ce que** l'extrémité libre (11 ; 11') de l'élément (10 ; 10') comprend au moins une zone de contact (13).

3. Carte rigide de circuit imprimé (1) selon la revendication 1 ou 2, **caractérisée en ce que** l'élément (10 ; 10') est formé de sorte qu'il puisse réaliser un mouvement prédéfini à l'extrémité libre de l'élément (10; 10') dans trois plans perpendiculaires les uns aux autres.

4. Carte rigide de circuit imprimé (1) selon l'une quelconque des revendications 1 à 3, **caractérisée en ce que** l'élément (10 ; 10') est formé de sorte qu'il assure une élasticité tridimensionnelle de l'extrémité libre (11 ; 11') de l'élément (10 ; 10').

5. Carte rigide de circuit imprimé (1) selon l'une quelconque des revendications 1 à 4, **caractérisée en ce que** la carte rigide de circuit imprimé (1) présente un substrat (5) isolant électriquement, qui comprend l'un des matériaux suivants : FR-2 (papier de coton avec résine phénolique), FR-3 (papier de coton et résine époxyde), FR-4 (tissu de verre et résine époxyde), FR-5 (tissu de verre et résine époxyde), FR-6 (natte de verre et polyester), G-10 (tissu de verre et résine époxyde), CEM-1 (papier de coton et résine époxyde), CEM-2 (papier de coton et résine époxyde), CEM-3 (tissu de verre et résine époxyde), CEM-4 (tissu de verre et résine époxyde), CEM-5 (tissu de verre et polyester).

6. Système de commande mécatronique avec une carte rigide de circuit imprimé (1) selon l'une quelconque des revendications 1 à 5.

7. Système de commande mécatronique selon la revendication 6, **caractérisé en ce que** la carte rigide de circuit imprimé (1) présente une pluralité de sections repliées (15), dans lequel des composants électroniques du système de commande mécatronique sont agencés sur les sections repliées et/ou sont connectés électriquement à celles-ci.

8. Système de commande mécatronique selon la revendication 5 ou 6, **caractérisé en ce qu'**il s'agit d'un module de commande d'une transmission automatique.

9. Procédé de fabrication d'une carte de circuit imprimé (1) avec les étapes suivantes consistant à :
- prévoir une carte rigide de circuit imprimé (1) qui présente au moins un élément intégral (10 ; 10'), et
- former l'élément (10 ; 10') de sorte qu'une extrémité libre (11 ; 11') de l'élément (10 ; 10') puisse effectuer un mouvement prédéfini dans au moins deux plans perpendiculaires l'un à l'autre,
**caractérisé en ce que**
la carte rigide de circuit imprimé précurseur (1) est estampée pour doter un élément (10 ; 10') avec une boucle (12 ; 12'), qui s'étend dans le plan (14) de l'élément (10 ; 10'), et laboucle (12 ; 12') est repliée dans une direction hors du plan (14) de l'élément (10 ; 10').

10. Procédé selon la revendication 9, **caractérisé en ce qu'**une carte rigide de circuit imprimé précurseur est formé de sorte que l'extrémité libre (11 ; 11') de l'élément (10 ; 10') présente au moins une zone de contact (13 ; 13').
